# FASCICULE DE BREVET EUROPEEN

(11) **EP 3 692 577 B1**
(45) Date de publication et mention de la délivrance du brevet: **08.06.2022**
(21) Numéro de dépôt: 18833954.3
(22) Date de dépôt: 17.12.2018
(51) Int. Cl.: H01L 27/15, H01L 33/08, H01L 33/10, H01L 33/46, H01L 33/60

(54) **PROCEDE DE REPORT DE STRUCTURES ELECTROLUMINESCENTES**
VERFAHREN ZUR ÜBERTRAGUNG VON LICHTEMITTIERENDEN STRUKTUREN
METHOD FOR TRANSFERRING LIGHT-EMITTING STRUCTURES

(30) Priorité: 22.12.2017 FR 1763169
(43) Date de publication de la demande: 12.08.2020
(73) Titulaire: Commissariat à l'énergie atomique et aux énergies alternatives, 75015 Paris (FR); Aledia, 38040 Grenoble (FR)
(72) Inventeur: VOLPERT, Marion, 38360 SASSENAGE (FR); BEIX, Vincent, 38600 FONTAINE (FR); LEVY, François, 38640 CLAIX (FR); IBRAHIM, Mario, 38600 FONTAINE (FR); DE MORO, Fabrice, 38160 SAINT MARCELLIN (FR)
(74) Mandataire: Brevalex
(86) Numéro de dépôt international: PCT/FR2018/053321
(87) Numéro de publication internationale: WO 2019/122644

(56) Documents cités:
- WO-A1-2017/216445
- FR-A1- 2 992 465
- US-A1- 2006 284 190

## Description

### DOMAINE TECHNIQUE

La présente invention concerne un procédé de report de structures électroluminescentes. En particulier, la présente invention concerne un procédé de report de structures électroluminescentes impliquant la formation préalable de murs réflecteurs destinés à isoler optiquement les structures électroluminescentes les unes des autres.

### ART ANTÉRIEUR

Un procédé, connu de l'état de la technique, de report de structures électroluminescentes formées sur une face, dite avant, d'un substrat support, et séparées les unes des autres par des chemins comprend les étapes suivantes :
a) une étape de formation de murs métalliques, notamment de murs métalliques épais avec une surface réflective, à l'aplomb des chemins, lesdits murs métalliques délimitant les structures électroluminescentes les unes des autres ;
b) une étape d'assemblage du substrat support et d'un substrat temporaire ;
c) une étape d'amincissement au moins partiel du substrat support ;
d) une étape de report des structures électroluminescentes sur le substrat d'accueil, ledit substrat comprenant des moyens d'interconnexion destinés à adresser de manière individuelle chacune des structures électroluminescentes.

À l'issue de l'étape d), les structures électroluminescentes sont en contact avec les moyens d'interconnexion par une de leur face, dite face arrière.

Les structures électroluminescentes peuvent comprendre des diodes électroluminescentes susceptibles d'émettre un rayonnement lumineux par une de leur face, dite face libre, et opposée à la face arrière.

Les diodes électroluminescentes peuvent être des diodes électroluminescentes 2D, à savoir planaires, et ainsi comprendre un empilement de films semi-conducteurs.

De manière alternative, les diodes électroluminescentes peuvent être des diodes électroluminescentes 3D comprenant, chacune, une pluralité de nanofils électroluminescents perpendiculaires à la face libre.

Le document US2006284190 décrit un procédé pour la fabrication de l'une diode électroluminescente comportant une première couche semi-conductrice dopée, une région active et une deuxième couche semi-conductrice dopée. Le procédé comprend une étape de report des structures électroluminescentes sur un substrat d'accueil.

Cependant, ce procédé de fabrication connu de l'état de la technique n'est pas satisfaisant.

En effet, la formation de murs métalliques, qui implique généralement un dépôt d'une couche épaisse d'une espèce métallique par exemple par électrodéposition, génère de fortes contraintes pouvant conduire à la dégradation, voire la destruction des structures électroluminescentes.

La dégradation des structures électroluminescentes peut se traduite par exemple par l'apparition de fissures au niveau de leur face libre par exemple.

Un but de la présente invention est donc de proposer un procédé de report de structures électroluminescentes délimitées par des murs métalliques dont la formation ne génère que peu ou pas de contraintes susceptibles de dégrader lesdites structures.

Un autre but de la présente invention est de proposer une procédé de report de structures électroluminescentes pour lequel les murs métalliques sont réalisés avant le report desdites structures, et donc avantageusement au niveau d'un substrat pourvue d'une pluralité de structures électroluminescentes.

### EXPOSÉ DE L'INVENTION

Les buts de l'invention sont, au moins en partie, atteints par un procédé de report de structures électroluminescentes formées sur une face, dite avant, d'un substrat support, et séparées les unes des autres par des chemins, le procédé comprenant les étapes successives suivantes :
a) formation d'une couche intermédiaire pourvue de premières régions, faites d'un premier matériau en recouvrement d'une face, dite face électroluminescente, des structures électroluminescentes, et de murs réflecteurs formés dans des tranchées à l'aplomb des chemins et séparant lesdites premières régions, lesdits murs comprenant un film métallique en recouvrement au moins des flancs des tranchées ainsi qu'un second matériau en recouvrement du film métallique et comblant lesdites tranchées;
b) assemblage de la couche intermédiaire et d'une face, dite face temporaire, d'un substrat temporaire ;
c) retrait au moins partiel du substrat support ;
d) report des structures électroluminescentes sur une face, dite face d'accueil, du substrat d'accueil,

l'un ou l'autre des premier et second étant destiné à assurer une adhésion entre la couche intermédiaire et la face temporaire.

Selon un mode de mise en oeuvre, l'écart relatif entre le coefficient d'expansion thermique du second matériau et celui du substrat support est inférieur à 20 %.

Selon un mode de mise en oeuvre, l'un ou l'autre des premier et second matériaux comprend un polymère thermoplastique destiné à assurer l'adhésion entre la couche intermédiaire et la face temporaire.

Selon un mode de mise en oeuvre, l'autre des premier et second matériau comprend un polymère thermodurcissable.

Selon un mode de mise en oeuvre, les premier et second matériaux sont des polyimides.

Selon un mode de mise en oeuvre, les premier et second matériaux ont une température de transition vitreuse comprise entre 150°C et 450°C, avantageusement comprise entre 250°C et 450°C.

Selon un mode de mise en oeuvre, l'étape b) comprend les étapes :
b1) une mise en contact de la couche intermédiaire avec la face temporaire,
b2) un traitement thermique de l'assemblage ainsi formé à une température inférieure à 500°C, avantageusement inférieure à 300°C.

Selon un mode de mise en oeuvre, l'étape a) comprend les étapes suivantes :
a1) formation des premières régions,
a2) la formation du film métallique qui comprend le dépôt d'une couche métallique en recouvrement des premières régions et du fond et des flancs des tranchées,
a3) remplissage des tranchées par le second matériau.

Selon un mode de mise en oeuvre, l'étape a1) comprend la formation d'une première couche faite du premier matériau, suivie de la définition des premières régions dans ladite couche, avantageusement, la définition des premières régions comprenant une étape de photolithographie.

Selon un mode de mise en oeuvre, l'étape a3) comprend la formation d'une seconde couche, faite du second matériau, en recouvrement des premières régions et remplissant les tranchées.

Selon un mode de mise en oeuvre, l'étape c) comprend un amincissement mécanique exécuté par abrasion.

Selon un mode de mise en oeuvre, l'étape c) est suivie d'une étape c1) de formation de contacts métalliques sur les structures électroluminescentes, la face d'accueil comprenant en outre des moyens d'interconnexion destinés à coopérer avec les contacts métallique et ainsi à adresser de manière individuelle chacune des structures électroluminescentes.

Selon un mode de mise en oeuvre, l'étape d) de report comprend les étapes :
d1) formation d'un assemblage comprenant le substrat d'accueil et le substrat temporaire, les structures électroluminescentes étant intercalées entre lesdits substrats ;
d2) le retrait du substrat temporaire, avantageusement par amincissement mécanique ou par décollement laser.

Selon un mode de mise en oeuvre, le procédé comprend une étape a4) de retrait partiel de la seconde couche et de la couche métallique, l'étape de retrait partiel étant exécutée de manière à conserver les murs réflecteurs.

Selon un mode de mise en oeuvre, le second matériau est le polymère thermoplastique et l'étape a4) est exécutée soit avant l'étape b) soit après l'étape d).

Selon un mode de mise en oeuvre, le second matériau est le polymère thermodurcissable et l'étape a4) est exécuté avant l'étape b).

Selon un mode de mise en oeuvre, les structures électroluminescentes comprennent chacune une couche active intercalée entre une première couche de semi-conducteur et une seconde couche de semi-conducteur.

Selon un mode de mise en oeuvre, chaque structure électroluminescente comprend une pluralité de nanofils perpendiculaires à la face électroluminescente.

Selon un mode de mise en oeuvre, les structures électroluminescentes sont agencées de manière matricielle.

Selon un mode de mise en oeuvre, l'étape d) est suivie d'une étape e), de retrait des premières régions et conservant les murs réflecteurs, destinée à mettre à nu les faces électroluminescentes.

### BRÈVE DESCRIPTION DES DESSINS

D'autres caractéristiques et avantages apparaîtront dans la description qui va suivre du procédé de report de structures électroluminescentes selon l'invention, donnés à titre d'exemples non limitatifs, en référence aux dessins annexés dans lesquels :
- les figures la à 1j sont des représentations schématiques, selon un plan de coupe perpendiculaire à la face avant du substrat support, du procédé de report de structures électroluminescentes selon un premier mode de réalisation de la présente invention,

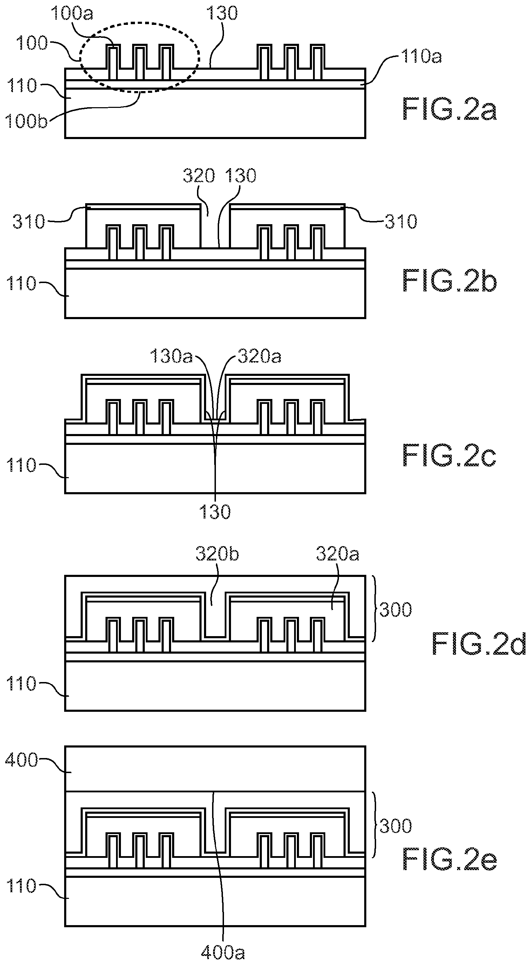

- les figures 2a à 2i sont des représentations schématiques, selon un plan de coupe perpendiculaire à la face avant du substrat support, du procédé de report de structures électroluminescentes selon un second mode de réalisation de la présente invention,

### EXPOSÉ DÉTAILLÉ DE MODES DE RÉALISATION PARTICULIERS

L'invention décrite de manière détaillée ci-dessous met en oeuvre un procédé de report de structures électroluminescentes sur une face, dite face d'accueil, d'un substrat d'accueil. La face d'accueil est par ailleurs pourvue de moyens d'interconnexion destinés à adresser de manière individuelle chacune desdites structures. Les structures électroluminescentes sont initialement formées sur un substrat support et sont séparées par des chemins.

Il est alors proposé dans la présente invention de former des murs réflecteurs, à l'aplomb des chemins, qui comprennent un polymère support (le second polymère) supportant sur ses flancs un film métallique. Une telle structure de murs réflecteurs permet de réduire les contraintes s'exerçant sur les structures électroluminescentes au cours du procédé de report selon la présente invention.

Par ailleurs, les mus réflecteurs, au sens de la présente invention, peuvent être réalisés sur l'ensemble des structures électroluminescentes reposant sur un substrat support.

Aux figures la à 1j et 2a à 2i, on peut voir des exemples de mise en oeuvre du procédé de report de structures électroluminescentes 100 sur un substrat d'accueil 500.

Par « structure électroluminescente », on entend généralement une structure qui, dès lors qu'elle est traversée par un courant, émet un rayonnement lumineux.

À cet égard, les structures électroluminescentes 100 sont susceptibles d'émettre le rayonnement lumineux par leur face électroluminescente 100a (figures la et 2a).

Par « rayonnement lumineux », on entend par exemple un rayonnement dans une gamme de longueurs d'ondes du domaine visible, par exemple dans une gamme de longueurs d'ondes comprise entre 400 µm et 700 µm.

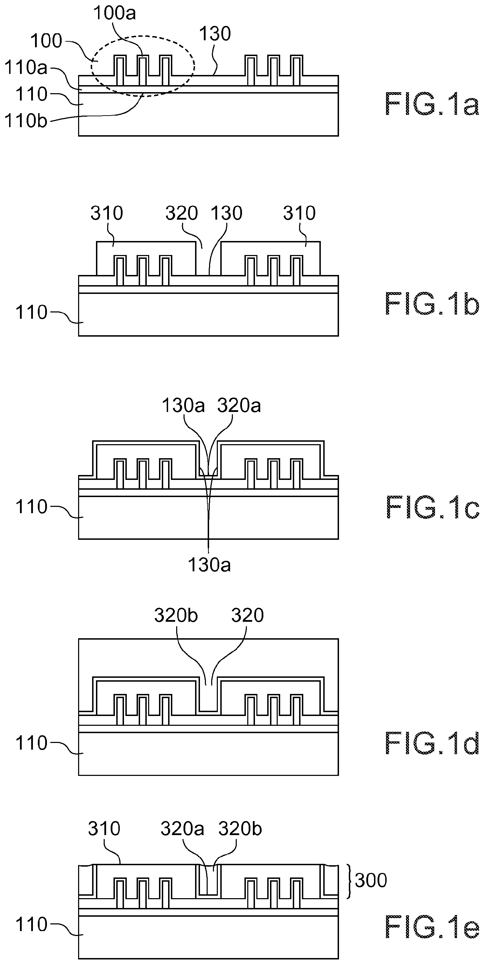

Les structures électroluminescentes 100 sont formées sur une face, dite face avant 110a, d'un substrat support 110, et séparées les unes des autres par des chemins 130 (figures 1b et 2b).

Par « chemin », on entend des bandes d'une largeur prédéterminée, par exemple comprise entre 1µm et 50 µm, avantageusement comprise entre 5 µm et 10 µm, et délimitant les structures électroluminescentes 100.

Les structures électroluminescentes 100 comprennent une face opposée à la face électroluminescente 100a, et dite face arrière 100b (figures la et 2a).

Les structures électroluminescentes 100 reposent par leur face arrière 100b sur la face avant du substrat support 110.

Selon une première alternative, les structures électroluminescentes 100 peuvent comprendre une couche active intercalée entre une première couche de semi-conducteur et une seconde couche de semi-conducteur.

La première couche de semi-conducteur peut comprendre du GaN de type n (par type n, on entend dopé avec des espèces donneuses d'électrons).

La seconde couche de semi-conducteur peut comprendre du GaN de type p (par type p, on entend dopé avec des espèces donneuses de trous).

La couche active peut comprendre au moins un des matériaux choisi parmi : GaN, GaAs, InGaN, InGaAIP.

La couche active, la première couche de semi-conducteur et la seconde couche de semi-conducteur peuvent être formées par des techniques de dépôt de films par épitaxie sur la face avant 110a du substrat support 110.

La formation desdites couches fait appel à des techniques connues de l'homme du métier et n'est donc pas décrite en détails dans la présente invention.

Selon une seconde alternative, la structure électroluminescente 100 peut comprendre des nanofils perpendiculaires à la face électroluminescente 100a.

Par « microfil » ou « nanofil », on entend une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Chaque nanofil peut comprendre de façon non limitative un empilement formé, d'une zone d'InGaN-n, d'une zone active, d'une zone de GaN-p ou d'InGaN-p.

À cet égard, l'homme du métier peut consulter la demande de brevet [1] citée à la fin de la description, et plus particulièrement, de la page 19 ligne 24 à la page 20 ligne 10.

L'ensemble des nanofils d'une structure électroluminescente 100 repose avantageusement sur la face avant 110a du substrat support 110.

La pluralité de structures électroluminescentes 100 peut être agencée, par exemple, sous forme matricielle.

Par « forme matricielle », on entend un maillage à N lignes et M colonnes.

Chaque structure électroluminescente 100 est alors disposée à l'intersection d'une ligne avec une colonne du maillage.

Le procédé selon l'invention comprend alors une étape a) de formation d'une couche intermédiaire 300 (figure le et 2d) sur la face avant 110a du substrat support 110. En d'autres termes, la couche intermédiaire 300 est formée en recouvrement des structures électroluminescentes 100 et des chemins 130.

La couche intermédiaire 300 comprend des premières régions 310, faites d'un premier matériau, en recouvrement de la face électroluminescente 100a et séparées par des tranchées 320 à l'aplomb des chemins 130 (figure 1b et 2b) et dans lesquelles sont formées des murs réflecteurs. La largeur des tranchées 320 est inférieure ou égale à la largeur des chemins 130.

Les premières régions 310 peuvent présenter une épaisseur comprise entre 2 µm et 20µm, avantageusement entre 5 µm et 15µm.

Les tranchées 320 comprennent un fond 130a et des flancs 130b.

Les murs réflecteurs comprennent un film métallique 320a (figures 1c et 2c) en recouvrement au moins des flancs des tranchées 320, et avantageusement de leur fond 130a.

Les murs réflecteurs comprennent également un second matériau 320b en recouvrement du film métallique 320a et comblant les tranchées (figure 1d, le et 2d).

L'épaisseur du film métallique 320a peut être comprise entre 50nm à 2µm préférentiellement entre 100nm et 300nm.

L'un et/ou l'autre des premier et second matériaux est destiné à assurer une adhésion entre la couche intermédiaire 300 et une face, dite face temporaire 400a, d'un substrat temporaire 400 à l'issue d'une étape d'assemblage b) décrite dans la suite de la description.

Par « assurer une adhésion », on entend un assemblage pour lequel l'énergie d'adhésion est supérieure à 0,5 J.cm⁻².

L'énergie d'adhésion est généralement mesurée par la technique de Mazara rappelée dans le document [2] cité à la fin de la description.

Le matériau thermoplastique est destiné à assurer une adhésion entre la couche intermédiaire 300 et une face, dite temporaire 400a, d'un substrat temporaire 400 à l'issue d'une étape d'assemblage b) décrite dans la suite de la description.

Dès lors qu'au moins un parmi le premier et le second matériau est destiné à assurer une adhésion entre la couche intermédiaire 300 et la face temporaire 400a, il est entendu que ce dernier est en contact avec ladite face temporaire 400a à l'issue de l'étape b) d'assemblage.

Le second matériau peut avantageusement présenter un coefficient d'expansion thermique s'écartant d'au plus 20% de celui du substrat support.

Dépendamment des différents modes de réalisation de la présente invention, et en particulier de l'étape a), l'un ou l'autre des premier et second matériaux peut comprendre un polymère thermoplastique.

De manière complémentaire, l'autre des premier et second matériaux peut comprendre un polymère thermodurcissable.

Par « polymère thermoplastique », on entend des matériaux composés de chaînes polymères linéaires avec peu ou pas de groupes ramifiés ou latéraux. Il résulte que ces chaînes peuvent facilement glisser les unes par rapport aux autres lorsqu'elles sont chauffées au-dessus de leur température de transition vitreuse Tg sans dommage pour le polymère.

Par « polymère thermodurcissable », on entend des matériaux qui subissent une réaction chimique lorsqu'ils sont initialement chauffés et durcis pour former un réseau réticulé tridimensionnel. Dès lors qu'ils sont réticulés, ces matériaux ont une structure figée qui ne peut être modifiée même lorsqu'ils sont chauffés à une température supérieure à leur température de transition vitreuse.

De manière avantageuse les polymères thermoplastique et thermodurcissable peuvent comprendre des polyimides.

Un polyimide thermodurcissble peut comprendre au moins un des polymères choisi parmi : PI2611, PIQ L-100.

Un polyimide destiné à assurer l'adhésion entre la couche intermédiaire 300 et la face temporaire 400a, dit aussi polyimide adhésif, peut comprendre au moins un des polymères choisi parmi : HD3007, HD-7010.

Le polymère thermoplastique peut, par exemple, comprendre une colle du type HD7010 ou HD3007 de la société Hitachi Chemical DuPont Microsystems . Ce polymère présente l'avantage d'être photosensible, et donc de permettre la définition de motifs selon un procédé photo lithographique.

Le polymère thermodurcissable peut, par exemple, comprendre le composé PI2611 de la société Hitachi Chemical DuPont Microsystems.

Toujours de manière avantageuse, le polymère thermoplastique et le polymère thermodurcissable peuvent présenter une température de transition vitreuse comprise entre 150°C et 450°C, avantageusement comprise entre 250°C et 450°C.

Ainsi selon un premier mode de réalisation de l'étape a) (figure 1b à le), le premier matériau formant les premières régions est destiné à assurer l'adhésion entre la couche intermédiaire 300 et la face temporaire 400a. Les premières régions 310 présentent donc une face exposée à l'environnement extérieur à l'issue de l'étape a) de formation de la couche intermédiaire 300 (figure le).

De manière avantageuse, le premier matériau peut comprendre un polymère thermoplastique.

Toujours selon ce premier mode de réalisation, le second matériau 320b, qui peut comprendre le matériau thermodurcissable, est en recouvrement du film métallique 320a et comble les tranchées 320. En particulier, afin de permettre l'adhésion entre les premières régions 310 et la face temporaire 400a, il est entendu que le second matériau est en affleurement, voire en retrait, par rapport au plan formé par les faces exposées à l'environnement extérieur des premières régions 310.

Selon un second mode de réalisation de l'étape a), le second matériau est destiné à assurer l'adhésion entre la couche intermédiaire 300 et la face temporaire 400a.

À cet égard, le second matériau peut comprendre un polymère thermoplastique.

Les premières régions 310 peuvent être faites d'un polymère thermodurcissable.

Par ailleurs, le film métallique 320a forme un film continu qui recouvre également les premières régions 310 (figures 2c et 2d).

Toujours selon ce second mode de réalisation, le second matériau 320b forme également un film continu en recouvrement du film métallique 320a.

Quel que soit le mode de réalisation considéré, l'étape a) de formation de la couche intermédiaire 300 peut comprendre les étapes suivantes :
a1) formation des premières régions 310 (figures 1b et 2b),
a2) la formation du film métallique qui comprend le dépôt d'une couche métallique en recouvrement des premières régions 310 et du fond et des flancs des tranchées (figures 1c et 2c),
a3) remplissage des tranchées par le second matériau 320b (figures 1d, 1e, et 2d).

L'étape a1) comprend par exemple la formation d'une première couche faite du premier matériau, suivie de la définition des premières régions 310 dans ladite couche. La première couche peut être formée par exemple en répandant le premier matériau, sous forme liquide, sur la face avant 110a du substrat support 110 à l'aide d'une tournette par exemple.

Si le premier matériau est photosensible, la définition des premières régions peut être exécutée par une étape de photo lithographie.

En particulier, l'étape de photo lithographie peut comprendre une étape d'exposition à un rayonnement lumineux, par exemple un rayonnement ultraviolet, à travers un masque photo lithographique de la première couche, suivie d'une étape de développement destinée à révéler les tranchées 320.

De manière alternative, la définition des premières régions 310 peut comprendre une étape de gravure, par exemple une gravure plasma (notamment avec un plasma O₂), à travers un masque, dit masque dur (« hard mask » selon la terminologie anglo-saxonne).

Le masque dur peut comprendre par exemple une couche de SiO₂, notamment une couche de SiO₂ de 100 nm d'épaisseur.

La couche métallique, formée à l'étape a2), peut comprendre au moins une des espèces métalliques choisie parmi : aluminium, l'argent, le Ruthénium choisis pour leur bonne réflectivité optique.

L'étape a2) peut être exécutée par évaporation ou par bombardement d'une cible métallique.

L'étape a2) peut être directement suivie d'une étape a2bis) de gravure du film métallique adaptée pour ne conserver ladite couche métallique que sur les flancs des tranchées. Cette étape de gravure peut être exécutée par plasma directif avant la mise en oeuvre de l'étape a3).

L'étape a3) peut comprendre la formation d'une seconde couche, faite du second matériau, en recouvrement des premières régions 310 et remplissant les tranchées 320.

Selon le premier mode de réalisation, l'étape a3) peut être suivie d'une étape a4) (figure le) de retrait partiel de la seconde couche et de la couche métallique, l'étape de retrait partiel étant exécutée de manière à conserver le second matériau 320b et le film métallique 320a dans les tranchées 320. L'étape a4) peut par exemple être exécutée par polissage mécano-chimique (« CMP » ou « Chemical Mechanical Planarization » selon la terminologie anglo-saxonne).

De manière alternative, l'étape a4) peut comprendre une étape de retrait de la seconde couche par polissage mécano-chimique s'arrêtant sur la couche métallique. La couche métallique en recouvrement des premières régions est alors gravée par gravure sèche (par exemple par plasma) ou par gravure humide.

De manière complémentaire à cette alternative, une couche d'arrêt du polissage est formée en recouvrement de la couche métallique.

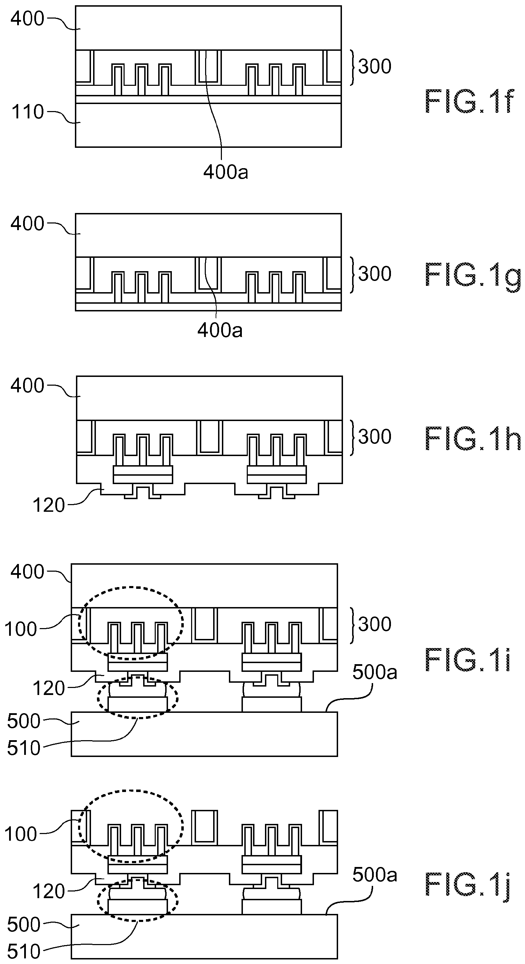

L'étape a) de formation de la couche intermédiaire 300 est alors suivie d'une étape b) d'assemblage de la face avant 110a et d'une face, dite face temporaire 400a, d'un substrat temporaire 400 (figure 1f et 2e). En d'autres termes, l'étape d'assemblage comprend la mise contact de la couche intermédiaire 300 avec la face temporaire 400a. Cette mise en contact peut être accompagnée d'un effort exercé sur l'un et l'autre des substrats support 110 et temporaire 400 de manière à forcer l'adhésion entre la couche intermédiaire 300 et la face temporaire 400a.

Par ailleurs, l'étape b) peut également comprendre une étape de traitement thermique exécutée à une température inférieure à 500°C, avantageusement inférieure à 400°C, de manière à renforcer l'adhésion de la couche intermédiaire sur la face temporaire 400a.

Le substrat temporaire 400 peut avantageusement comprendre au moins un des matériaux choisi parmi : verre, silicium, céramique.

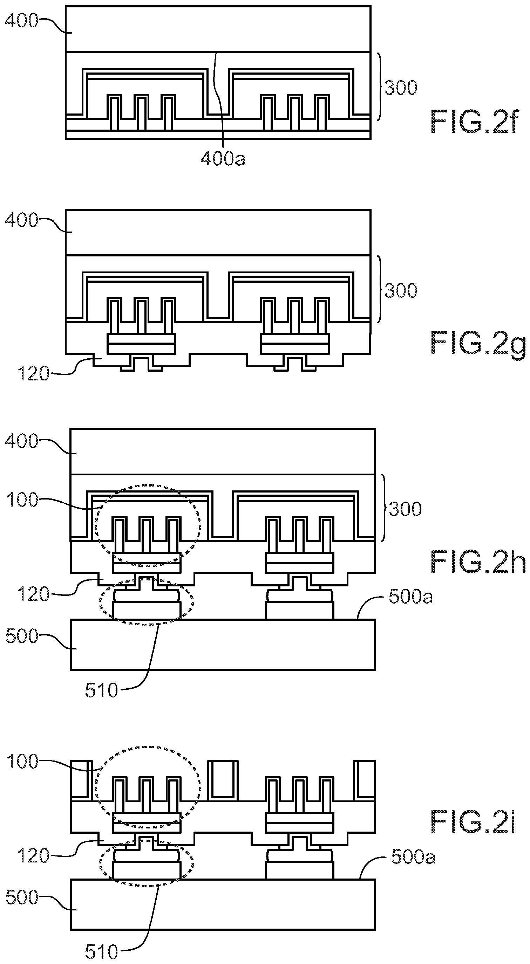

L'étape b) est suivie d'une étape c) de retrait ou d'amincissement au moins partiel du substrat support 110 (figures 1g et 2f).

L'étape c) peut être exécutée par abrasion mécanique (« grinding » selon la terminologie anglo-saxonne) et/ou par gravure par voie liquide (par exemple avec une solution de KOH ou de TMAH) et/ou par gravure sèche (par exemple avec un plasma SF6).

L'étape c) peut également être suivie d'une étape c1) (figures 1h et 2g) de formation de contacts métalliques 120 au dos des structures électroluminescentes 100 (Par « au dos des structures », on entend sur une face opposée à la face électroluminescente).

La formation des contacts métalliques 120 est connue de l'homme du métier et n'est donc pas décrite plus en détails dans la présente invention.

L'étape c) est alors suivi d'une étape d) de report des structures électroluminescentes 100 sur une face, dite face d'accueil 500a, d'un substrat d'accueil 500 (figures 1i, 1j, 2h et 2i).

Par « report des structures électroluminescentes », on entend une étape d'adhésion des structures électroluminescentes sur une face d'un substrat d'accueil et de désolidarisation desdites structures du substrat temporaire.

En d'autres termes, à l'issue de l'étape d), les structures électroluminescentes 100 reposent sur le substrat d'accueil 500.

La face d'accueil 500a peut en outre comprendre des moyens d'interconnexion 510 destinés à coopérer avec les contacts métalliques de manière à adresser individuellement chacune des structures électroluminescentes 100.

Les moyens d'interconnexion 510 peuvent comprendre des plots métalliques (« pad » selon la terminologie anglo-saxonne), par exemple des plots métalliques faits d'un empilement de titane, de nickel et d'or associés avec des piliers de cuivre, étain argent.

L'étape d) comprend en particulier une étape d1) de formation d'un d'assemblage comprenant le substrat d'accueil 500 et le substrat temporaire 400, les structures électroluminescentes étant intercalées entre lesdits substrats.

L'étape d1) est alors suivie d'une étape d2) de retrait du substrat temporaire.

L'étape d2) peut être exécutée par amincissement mécanique, par exemple par abrasion suivi d'une étape de polissage mécano-chimique et/ou de retrait par voie liquide et/ou par voie sèche.

De manière alternative, le substrat temporaire 400, dès lors qu'il est transparent, peut être désolidarisé (ou détaché) de la couche intermédiaire 300 à l'aide d'un rayonnement laser.

À l'issue de l'étape d) les structures électroluminescentes 100 reposent ainsi sur la face d'accueil 500a du substrat d'accueil 500.

L'étape d) peut alors être suivie d'une étape e), de retrait des premières régions conservant les murs réflecteurs, destinée à mettre à nu les faces électroluminescentes.

L'étape e) conserve notamment des murs réflecteurs délimitant optiquement les structures électroluminescentes les unes des autres.

Ainsi, dès lors que la couche intermédiaire est formée selon le premier mode de réalisation, l'étape e) comprend le retrait des premières régions.

Le retrait des premières régions peut comprendre une gravure, par exemple une gravure par voie humide, des premières régions. En particulier, l'étape de gravure peut être précédée d'une étape de masquage des murs réflecteurs de manière à protéger ces derniers lors de ladite étape de gravure.

Dès lors que la couche intermédiaire est formée selon le second mode de réalisation, l'étape e) comprend l'amincissement de la seconde couche.

Le retrait de la seconde couche peut être exécuté par gravure, par exemple par gravure plasma (notamment un plasma de dioxygène).

L'étape e) comprend également le retrait de la couche métallique à l'aplomb des structures électroluminescentes. Le retrait de la couche métallique peut être exécuté avec un plasma comprenant par exemple du BCl₃ ou du Cl₂ dans le cas d'une couche d'aluminium.

Enfin, l'étape e) comprend le retrait des premières régions, par exemple avec un plasma de CF₄ ou de CHF₃.

La présente invention, en particulier la formation des murs réflecteurs, ne requiert pas le dépôt d'une couche métallique épaisse susceptible de générer des contraintes pouvant endommager voire détruire les structures électroluminescentes.

Par ailleurs, la mise en oeuvre des premier et second polymères permet d'ajuster le coefficient d'expansion thermique de la couche intermédiaire et limite également la génération de contrainte lors de l'exécution du procédé de report.

Le procédé de report ainsi proposée limite l'endommagement des structures électroluminescentes.

Les murs réflecteurs, selon la présente invention, comprennent un film métallique disposé sur les flancs d'un support formé par le second matériau, et ne nécessitent le dépôt que d'une faible épaisseur de métal.

### RÉFÉRENCES

[1] FR3012676
[2] Maszara et al., « Bonding of silicon wafers for silicon-on-insulator », J. Appl. Phys. 64 (1 0), 15 November 1988.

## Revendications

1. Procédé de report de structures électroluminescentes (100) formées sur une face, dite face avant (110a), d'un substrat support (110), et séparées les unes des autres par des chemins (130), le procédé comprenant les étapes successives suivantes :
a) formation d'une couche intermédiaire (300) pourvue de premières régions (310), faites d'un premier matériau en recouvrement d'une face, dite face électroluminescente (100a), des structures électroluminescentes (100), et de murs réflecteurs formés dans des tranchées (320) à l'aplomb des chemins (130) et séparant lesdites premières régions (310), lesdits murs comprenant un film métallique (320a) en recouvrement au moins des flancs des tranchées (320) ainsi qu'un second matériau (320b) en recouvrement du film métallique (320a) et comblant lesdites tranchées ;
b) assemblage de la couche intermédiaire (300) avec une face, dite face temporaire (400a), d'un substrat temporaire (400) ;
c) retrait au moins partiel du substrat support (110) ;
d) report des structures électroluminescentes (100) sur une face, dite face d'accueil (500a), d'un substrat d'accueil (500) distinct du substrat temporaire (400),
au moins un des premier et second matériaux étant destiné à assurer une adhésion entre la couche intermédiaire (300) et la face temporaire (400a).

2. Procédé selon la revendication 1, dans lequel l'écart relatif entre les coefficients d'expansion thermique entre le second matériau et le substrat support est inférieur à 20 %.

3. Procédé selon la revendication 1 ou 2, dans lequel l'un ou l'autre des premier et second matériaux comprend un polymère thermoplastique destiné à assurer l'adhésion entre la couche intermédiaire et la face temporaire, avantageusement, l'autre des premier et second matériau comprend un polymère thermodurcissable.

4. Procédé selon l'une des revendications 1 à 3, dans lequel les premier et second matériaux sont des polyimides.

5. Procédé selon l'une des revendications 1 à 4, dans lequel les premier et second matériaux ont une température de transition vitreuse comprise entre 150°C et 450°C, avantageusement comprise entre 250°C et 450°C.

6. Procédé selon l'une des revendications 1 à 5, dans lequel l'étape b) comprend les étapes :
b1) une mise en contact de la couche intermédiaire (300) avec la face temporaire (400a)
b2) un traitement thermique de l'assemblage ainsi formé à une température inférieure à 500°C, avantageusement inférieure à 300°C.

7. Procédé selon l'une des revendications 1 à 6, dans lequel l'étape a) comprend les étapes suivantes :
a1) formation des premières régions (310),
a2) la formation du film métallique (320a) qui comprend le dépôt d'une couche métallique en recouvrement des premières régions (310) et au moins des flancs des tranchées (320),
a3) remplissage des tranchées (320) par le second matériau (320b).

8. Procédé selon la revendication 7, dans lequel l'étape a1) comprend la formation d'une première couche faite du premier matériau, suivie de la définition des premières régions (310) dans ladite couche, avantageusement, la définition des premières régions (310) comprend une étape de photolithographie, avantageusement, l'étape a3) comprend la formation d'une seconde couche, faite du second matériau (320b), en recouvrement des premières régions (310) et remplissant les tranchées (320).

9. Procédé selon l'une des revendications 1 à 8, dans lequel l'étape c) est suivie d'une étape c1) de formation de contacts métalliques au niveau d'une face, opposée à la face électroluminescente, des structures électroluminescentes (100), la face d'accueil (500a) comprenant en outre des moyens d'interconnexion destinés à coopérer avec les contacts métallique et ainsi à adresser de manière individuelle chacune des structures électroluminescentes (100).

10. Procédé selon l'une des revendications 1 à 9, dans lequel l'étape d) de report comprend les étapes :
d1) formation d'un assemblage comprenant le substrat d'accueil (500) et le substrat temporaire (400), les structures électroluminescentes (100) étant intercalées entre lesdits substrats ;
d2) le retrait du substrat temporaire (400), avantageusement par amincissement mécanique ou par décollement laser.

11. Procédé selon l'une des revendications 1 à 10 en combinaison avec la revendication 7, dans lequel le procédé comprend une étape a4) de retrait partiel de la seconde couche et de la couche métallique, l'étape de retrait partiel étant exécutée de manière à conserver les murs réflecteurs, avantageusement, le second matériau (320b) est le polymère thermoplastique et l'étape a4) est exécutée soit avant l'étape b) soit après l'étape d) ou le second matériau (320b) est le polymère thermodurcissable et l'étape a4) est exécuté avant l'étape b).

12. Procédé selon l'une des revendications 1 à 11, dans lequel les structures électroluminescentes (100) comprennent chacune une couche active intercalée entre une première couche de semi-conducteur et une seconde couche de semi-conducteur.

13. Procédé selon l'une des revendications 1 à 12, dans lequel chaque structure électroluminescente comprend une pluralité de nanofils perpendiculaires à la face électroluminescente.

14. Procédé selon l'une des revendications 1 à 13, dans lequel les structures électroluminescentes (100) sont agencées de manière matricielle.

15. Procédé selon l'une des revendications 1 à 14, dans lequel l'étape d) est suivie d'une étape e), de retrait des premières région et conservant les murs réflecteurs, destinée à mettre à nu les faces électroluminescentes.

## Patentansprüche

1. Verfahren zur Übertragung von lichtemittierenden Strukturen (100), die auf einer Fläche, Vorderfläche (110a) genannt, eines Trägersubstrats (110) gebildet sind und durch Pfade (130) voneinander getrennt sind, wobei das Verfahren die folgenden aufeinanderfolgenden Schritte umfasst:
a) Bildung einer Zwischenschicht (300), die mit ersten Bereichen (310) versehen ist, die aus einem ersten Material gebildet sind, das eine Fläche bedeckt, lichtemittierende Fläche (100a) genannt, lichtemittierenden Strukturen (100) und reflektierenden Wänden, die in den Schneisen (320) rechtwinklig zu den Pfaden (130) gebildet sind und die ersten Bereiche (310) abtrennen, wobei die Wände einen Metallfilm (320a) umfassen, der mindestens die Flanken der Schneisen (320) bedeckt sowie ein zweites Material (320b), das den Metallfilm (320a) bedeckt und die Schneisen auffüllt;
b) Verbinden der Zwischenschicht (300) mit einer Fläche, temporäre Fläche (400a) genannt, eines temporären Substrats (400);
c) Entfernen, mindestens teilweise, des Trägersubstrats (110);
d) Übertragung von lichtemittierenden Strukturen (100) auf eine Fläche, Aufnahmefläche (500a) genannt, eines Aufnahmesubstrats (500), das sich vom temporären Substrat (400) unterscheidet,
wobei mindestens eines des ersten und zweiten Materials dazu bestimmt ist, eine Haftung zwischen der Zwischenschicht (300) und der temporären Fläche (400a) zu gewährleisten.

2. Verfahren nach Anspruch 1, wobei die relative Abweichung zwischen den Wärmeausdehnungskoeffizienten zwischen dem zweiten Material und dem Trägersubstrat weniger als 20 % beträgt.

3. Verfahren nach Anspruch 1 oder 2, wobei das eine oder das andere des ersten und zweiten Materials ein thermoplastisches Polymer umfasst, das dazu bestimmt ist, die Haftung zwischen der Zwischenschicht und der temporären Fläche zu gewährleisten, vorteilhafterweise umfasst das andere des ersten und zweiten Materials ein duroplastisches Polymer.

4. Verfahren nach einem der Ansprüche 1 bis 3, wobei das erste und zweite Material Polyimide sind.

5. Verfahren nach einem der Ansprüche 1 bis 4, wobei das erste und zweite Material eine Glasübergangstemperatur zwischen 150 °C und 450 °C haben, vorteilhafterweise zwischen 250 °C und 450 °C.

6. Verfahren nach einem der Ansprüche 1 bis 5, wobei der Schritt b) die Schritte umfasst:
b1) eine Kontaktbildung der Zwischenschicht (300) mit der temporären Fläche (400a),
b2) eine Wärmebehandlung der so gebildeten Verbindung bei einer Temperatur unter 500 °C, vorteilhafterweise unter 300 °C.

7. Verfahren nach einem der Ansprüche 1 bis 6, wobei der Schritt a) die folgenden Schritte umfasst:
a1) Bildung der ersten Bereiche (310),
a2) Bildung des Metallfilms (320a), die die Beschichtung einer Metallschicht umfasst, die die ersten Bereiche (310) und mindestens die Flanken der Schneisen (320) bedeckt,
a3) Auffüllen der Schneisen (320) mit dem zweiten Material (320b).

8. Verfahren nach Anspruch 7, wobei der Schritt a1) die Bildung einer ersten Schicht umfasst, die aus dem ersten Material gebildet ist, gefolgt von der Definition der ersten Bereiche (310) in der Schicht, vorteilhafterweise umfasst die Definition der ersten Bereiche (310) einen Schritt der Fotolithografie, vorteilhafterweise umfasst der Schritt a3) die Bildung einer zweiten Schicht, die aus dem zweiten Material (320b) gemacht ist, die die ersten Bereiche (310) bedeckt und die Schneisen (320) auffüllt.

9. Verfahren nach einem der Ansprüche 1 bis 8, wobei der Schritt c) gefolgt ist von einem Schritt c1) der Bildung von Metallkontakten im Bereich einer Fläche, die der lichtemittierenden Fläche gegenüberliegt, und lichtemittierenden Strukturen (100), wobei die Aufnahmefläche (500a) ferner Verbundmittel umfasst, die zum Zusammenwirken mit den Metallkontakten bestimmt sind und somit um auf jede der lichtemittierenden Strukturen (100) einzeln zu verweisen.

10. Verfahren nach einem der Ansprüche 1 bis 9, wobei der Schritt d) der Übertragung die Schritte umfasst:
d1) Bildung einer Verbindung, die das Aufnahmesubstrat (500) und das temporäre Substrat (400) umfasst, wobei die lichtemittierenden Strukturen (100) zwischen den Substraten interkaliert sind;
d2) die Entfernung des temporären Substrats (400), vorteilhafterweise durch mechanisches Ausdünnen oder Laserablösung.

11. Verfahren nach einem der Ansprüche 1 bis 10 in Kombination mit Anspruch 7, wobei das Verfahren einen Schritt a4) des teilweisen Entfernens der zweiten Schicht und der Metallschicht umfasst, wobei der Schritt des teilweisen Entfernens so ausgeführt wird, dass die reflektierenden Wände erhalten bleiben, vorteilhafterweise ist das zweite Material (320b) das thermoplastische Polymer und der Schritt a4) wird entweder vor dem Schritt b) oder nach dem Schritt d) ausgeführt oder das zweite Material (320b) ist das duroplastische Polymer und der Schritt a4) wird vor dem Schritt b) ausgeführt.

12. Verfahren nach einem der Ansprüche 1 bis 11, wobei die lichtemittierenden Strukturen (100) jeweils eine aktive Schicht umfassen, die zwischen einer ersten Halbleiterschicht und einer zweiten Halbleiterschicht interkaliert ist.

13. Verfahren nach einem der Ansprüche 1 bis 12, wobei jede lichtemittierende Struktur eine Vielzahl von Nanodrähten umfasst, perpendikular zur lichtemittierenden Fläche.

14. Verfahren nach einem der Ansprüche 1 bis 13, wobei die lichtemittierenden Strukturen (100) matrixartig angeordnet sind.

15. Verfahren nach einem der Ansprüche 1 bis 14, wobei der Schritt d) gefolgt ist von einem Schritt e) der Entfernung der ersten Bereiche und die reflektierenden Wände erhaltend, bestimmt um die lichtemittierenden Flächen freizulegen.

## Claims

1. Method for transferring electroluminescent structures (100) formed on a face, referred to as the front face (110a), of a supporting substrate (110) and separated from each other by tracks (130), the method comprising the following successive steps:
a) formation of an intermediate layer (300) provided with first regions (310), made from a first material covering a face, referred to as the electroluminescent face (100a), of the electroluminescent structures (100), and reflective walls formed in trenches (320) above the tracks (130) and separating said first regions (310), said walls comprising a metal film (320a) covering at least the sides of the trenches (320) as well as a second material (320b) covering the metal film (320a) and filling in said trenches;
b) assembling the intermediate layer (300) and a face, referred to as the temporary face (400a), of a temporary substrate (400);
c) at least partial removal of the supporting substrate (110);
d) transfer of the electroluminescent structures (100) onto a face, referred to as the accommodating face (500a), of an accommodating substrate (500) distinct from the temporary substrate (400),
at least one of the first and second materials being intended to provide adhesion between the intermediate layer (300) and the temporary face (400a).

2. Method according to claim 1, wherein the relative difference between the thermal expansion coefficient of the second material and that of the supporting substrate is less than 20%.

3. Method according to claim 1 or 2, wherein one or other of the first and second materials comprises a thermoplastic polymer intended to provide adhesion between the intermediate layer and the temporary face, advantageously, the other one of the first and second materials comprises a thermosetting polymer.

4. Method according to one of claims 1 to 3, wherein the first and second materials are polyimides.

5. Method according to one of claims 1 to 4, wherein the first and second materials have a glass transition temperature between 150°C and 450°C, advantageously between 250°C and 450°C.

6. Method according to one of claims 1 to 5, wherein step b) comprises the following steps:
b1) putting the intermediate layer (300) in contact with the temporary face (400a)
b2) heat treatment of the assembly thus formed at a temperature of less than 500°C, advantageously less than 300°C.

7. Method according to one of claims 1 to 6, wherein step a) comprises the following steps:
a1) formation of the first regions (310),
a2) formation of the metal film (320a) that comprises the deposition of a metal layer covering the first regions (310) and at least the sides of the trenches (320),
a3) filling of the trenches (320) with the second material (320b).

8. Method according to claim 7, wherein step a1) comprises the formation of a first layer made from the first material, followed by the definition of the first regions (310) in said layer, advantageously, the definition of the first regions (310) comprises a photolithography step, advantageously, step a3) comprises the formation of a second layer, made from the second material (320b), covering the first regions (310) and filling the trenches (320).

9. Method according to one of claims 1 to 8, wherein step c) is followed by a step c1) of formation of metal contacts on a face, opposite to the electroluminescent face, of the electroluminescent structures (100), the accommodating face (500a) further comprising interconnection means intended to cooperate with the metal contacts and thus to individually address each of the electroluminescent structures (100).

10. Method according to one of claims 1 to 9, wherein the transfer step d) comprises the steps of:
d1) formation of an assembly comprising the accommodating substrate (500) and the temporary substrate (400), the electroluminescent structures (100) being interposed between said substrates;
d2) removal of the temporary substrate (400), advantageously by mechanical thinning or by laser lift-off.

11. Method according to one of claims 1 to 10 in combination with claim 7, wherein the method comprises a step a4) of partial removal of the second layer and of the metal layer, the step of partial removal being carried out such that the reflective walls are kept, advantageously, the second material (320b) is the thermoplastic polymer and step a4) is executed either before step b) or after step d) or the second material (320b) is the thermosetting polymer and step a4) is executed before step b).

12. Method according to one of claims 1 to 11, wherein the electroluminescent structures (100) each comprise an active layer interposed between a first layer of semiconductor and a second layer of semiconductor.

13. Method according to one of claims 1 to 12, wherein each electroluminescent structure comprises a plurality of nanowires perpendicular to the electroluminescent face.

14. Method according to one of claims 1 to 13, wherein the electroluminescent structures (100) are arranged in a matrix fashion.

15. Method according to one of claims 1 to 14, wherein step d) is followed by a step e) of removal of the first regions and preserving the reflective walls, intended to bare the electroluminescent faces.
